(19) Europäisches Patentamt
European Patent Office
Office européen des brevets

(11) Publication number : **0 606 947 A1**

(12) # EUROPEAN PATENT APPLICATION

(21) Application number : **94200037.3**

(51) Int. Cl.$^5$ : **C08G 59/06,** H05K 1/03

(22) Date of filing : **10.01.94**

(30) Priority : **12.01.93 JP 19180/93**
**19.01.93 JP 23199/93**

(43) Date of publication of application :
**20.07.94 Bulletin 94/29**

(84) Designated Contracting States :
**AT BE DE FR GB IT SE**

(71) Applicant : **SHELL INTERNATIONALE RESEARCH MAATSCHAPPIJ B.V.**
**Carel van Bylandtlaan 30**
**NL-2596 HR Den Haag (NL)**

(72) Inventor : **Maeda, Kazuo, c/o Yuka Shell Epoxy KK, dept. ADMP**
**Nishiazabu Mitsui Building,**
**17-30 Nishiazabu**
**4-chome, Minato-ku, Tokyo 106 (JP)**
Inventor : **Watanabe, Takamasa C/0 Yuka Shell Epoxy kk DepADMP**
**Nishiazabu MitsuiBuilding**
**17-30 Nishiazabu 4-chome**
**Minato-ku Tokyo 106 (JP)**
Inventor : **Fukuzawa, Takao, c/o Yuka Shell Epoxy KK, Dep.ADMP**
**Nishiazabu MitsuiBuilding**
**17-30 Nishiazabu 4-chome**
**Minato-ku, Tokyo 106 (JP)**

(54) **Epoxy resin and epoxy resin compositions for electric laminates.**

(57) An epoxy resin (a), having a polydispersity index of molecular weight distribution (ratio of Mw/Mn) lower than 3.0, obtainable by reacting :
A) a difunctional epoxy resin having the skeleton of at least one bisphenol compound selected from bisphenol A, bisphenol F and tetrabromobisphenol A,
B) from 1 to 20% by weight based on the total weight of the components A, B and C, of a polyfunctional phenol compound, and
C) at least one bisphenol compound selected from bisphenol A, bisphenol F, and tetrabromobisphenol A.

EP 0 606 947 A1

The present invention relates to an epoxy resin, to an epoxy resin composition comprising such an epoxy resin, to laminates prepared with such a composition and to printed circuit boards comprising such a laminate.

Epoxy resin compositions are well known base materials for the preparation of laminates suitable as substrates of printed circuit boards.

Laminates produced from the known heat-resistant epoxy resin often show blistering, peeling, measling, and crazing when dipped in a soldering bath after immersion in boiling water. In addition, they are often too hard and brittle to be readily drilled.

The problem underlying the present invention thus can be seen in providing an epoxy resin base material for an epoxy resin composition, the latter being particularly suitable for the production of copper-clad epoxy resin laminates as substrates of printed circuit boards, which, before curing, readily impregnate into glass cloth and after curing, yield cured products showing at least a combination of the following properties: good impregnation into glass cloth, good heat resistance, good measling resistance, good drillability, and good adhesion to copper foil.

The present invention therefore relates to an epoxy resin (a), having a polydispersity index of molecular weight distribution (ratio of Mw/Mn) lower than 3.0, obtainable by reacting:

A) a difunctional epoxy resin having the skeleton of at least one bisphenol compound selected from bisphenol A, bisphenol F and tetrabromobisphenol A,

B) from 1 to 20% by weight based on the total weight of the components A, B and C, of a polyfunctional phenol compound, and

C) at least one bisphenol compound selected from bisphenol A, bisphenol F, and tetrabromobisphenol A.

The present invention further relates to an epoxy resin composition which comprises the epoxy resin (a) as defined above as a major component, a curing compound, and a curing accelerator.

As can be seen from the accompanying examples, the epoxy resin compositions according to the present invention provide superior impregnation into glass cloth, good heat resistance, measling resistance, drillability, and good adhesion to metal, as compared to epoxy resin compositions known in the art.

Polyfunctional phenol compounds suitable as component (B) are for example, (1) a polyfunctional phenol compound obtained by reacting an aldehyde or ketone compound having a hydroxyl group-substituted phenyl group with a phenol compound in the presence of an acid catalyst, (2) a polyfunctional phenol compound obtained by reacting a phenol-based dimethylol compound or phenol-based novolak dimethylol compound with a phenol compound in the presence of an acid catalyst, (3) a polyfunctional phenol compound obtained by reacting a phenol compound with formaldehyde in the presence of an acid catalyst and (4) a phenol novolak compound containing:

i) more than 20% by weight based on the total weight of phenol novolak compound (4) of trinuclear phenol novolak compound represented by formula I

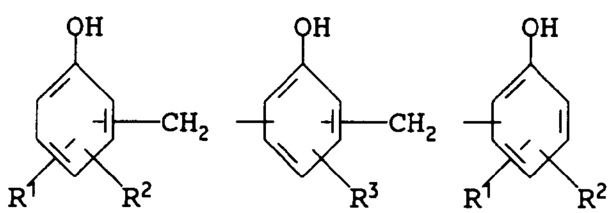

(I)

wherein $R^1$, $R^2$ and $R^3$ each independently is a hydrogen atom or an alkyl group having from 1 to 3 carbon atoms, and

ii) less than 20% by weight based on the total weight of phenol novolak compound (4) of a dinuclear phenol novolak compound, represented by the formula II

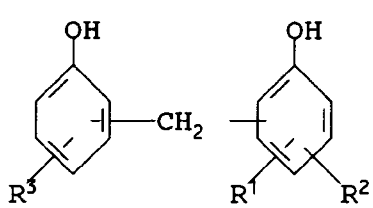

(II)

wherein $R^1$, $R^2$ and $R^3$ are as defined above.

Suitable aldehyde or ketone compounds having a hydroxyl group-substituted phenyl group used for production of the above compound (1) are for example, salicylaldehyde, p-hydroxy-benzaldehyde, and p-hydroxyacetophenone. Suitable phenol compounds used for production of the above compounds (1), (2), and (3) are for example, phenol, o-cresol, m-cresol, p-cresol, p-(t-butyl)-phenol, and bisphenol A.

Suitable phenol-based dimethylol compounds or phenol-based novolak dimethylol compounds used for production of the compound (2) are for example, o-cresoldimethylol compound, m-cresol-dimethylol compound, p-cresoldimethylol compound, dimethylolphenol compound, and a variety of phenol-based dinuclear dimethylol compounds represented by the below formula III

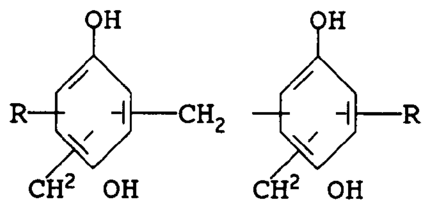 (III)

where each R is H or $CH_3$.

Examples of suitable compounds of the above formula III are: o-cresol dinuclear dimethylol compound, m-cresol dinuclear dimethyl compound, p-cresol dinuclear dimethylol compound, and phenol dinuclear dimethyl compound.

The phenol novolak containing compound (4) as referred to above may be prepared by reacting a phenolic compound of the formula IV

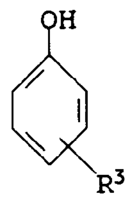 (IV)

wherein $R^3$ is a hydrogen atom or an alkyl group having from 1 to 3 carbon atoms,
with formaldehyde in the presence of a basic catalyst to prepare a resole, followed by reacting the resole with a phenolic compound of the formula V

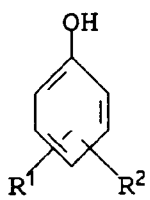 (V)

wherein $R^1$ and $R^2$ each independently is a hydrogen atom or an alkyl group having from 1 to 3 carbon atoms, in the presence of an acid catalyst.

Suitable compounds of the above formula IV are for example: phenol, o-cresol, m-cresol, p-cresol, and p-(t-butyl)phenol, whereas suitable compounds of the above formula V are for example the compounds of the above formula IV and in addition the xylenols.

The base catalysed reaction between a phenolic compound and formaldehyde and the acid catalysed reaction between a phenolic compound and a resole, are both well known in the art and therefore a detailed description thereof is left out.

For the preparation of epoxy resin (a) it is preferred to react the above-mentioned components (A), (B) and (C) at a temperature of from 100-200 °C for a period of from 60-200 minutes, preferably in the presence of a catalyst. Suitable catalysts are for example: imidazoles such as 1,2-dimethylimidazole and 2-methylimidazole; amines such as trimethylamine and triethylamine; ammonium salts such as tetramethylammonium bromide and tetramethylammonium chloride; phosphines such as triphenylphosphine; and phosphonium salts such as benzyltriphenylphosphonium chloride and ethyltriphenylphosphonium bromide.

It was found that in the above process the amount used therein of the polyfunctional phenol compound

as component (B) is critical with respect to the performance properties of the epoxy resin (a) prepared. When less than 1% by weight of this component (B) based on the total weight of the components (A), (B) and (C) is used the overall performance of epoxy resin (a) will not be satisfactory; whereas when more than 20% by weight of this component (B) is used based on the total weight of the components (A), (B) and (C), the polydispersity index of the epoxy resin (a) produced will be higher than 3.0, due to the higher percentage of high molecular weight segments, whereby the resin viscosity will be increased to such an extent that it will poorly impregnate glass cloth and as a consequence prepregs comprising the latter will have insufficient stability.

As indicated above the epoxy resin compositions according to the present invention comprise the epoxy resin (a) as the principal component.

However, epoxy resins having two or more epoxy groups per molecule differing from epoxy resin (a), may be used in the epoxy resin composition of the present invention in combination with epoxy resin (a).

Examples of such epoxy resins differing from epoxy resin (a) include glycidyl ether type epoxy resins, such as bisphenol A type epoxy resins phenol novolak type epoxy resin and cresol novolak type epoxy resins; glycidyl ester type epoxy resins; glycidyl amine type epoxy resins; linear aliphatic epoxy resins; alicyclic epoxy resins; heteroalicyclic epoxy resins; halogenated epoxy resins; and other polyfunctional epoxy resins. The amount of these epoxy resin(s) differing from epoxy resin (a) used should be less than 50% by weight based on the total amount of the epoxy resin (a) and the epoxy resin(s) differing from epoxy resin (a). If the amount of epoxy resin(s) differing from epoxy resin (a) used in the epoxy resin composition is more than 50% by weight, based on said total amount, laminates prepared with said epoxy resin composition do not meet the high performance standards of the compositions of the present invention.

Curing compounds suitable for use in epoxy resin compositions according to the present invention are for example: aromatic polyamines acid, anhydrides, phenol novolak resins and in particular dicyandiamide.

Curing accelerators suitable for use in the epoxy resin compositions according to the present invention are for example amines such as benzyldimethylamine, imidazole compounds and tertiary phosphines such as triphenylphosphine.

The epoxy resin composition of the present invention may further comprise a solvent in order to improve its impregnation into glass cloth. Suitable solvents are for example acetone, methyl ethyl ketone, toluene, xylene, methyl isobutyl ketone, ethyl acetate, ethylene glycol monomethyl ether, N,N-dimethylformamide, N,N-dimethylacetamide, methanol and ethanol. They may be used alone or in combination with one another.

If desired, the epoxy resin composition of the present invention may further comprise a variety of additives, such as for example flame retardants and fillers.

The epoxy resin composition of the present invention can be used for the preparation of copper-clad epoxy resin laminates according to methods known in the art, for example, by impregnating glass cloth therewith, drying the impregnated glass cloth by heating and thus forming a prepreg, laminating one or more prepreg(s) together with copper foil placed on one or both side(s) thereof, and finally heating the laminate under pressure.

The invention is illustrated by means of the following examples, which are not intended to restrict the scope of the present invention.

In these examples, "parts" and "%" mean "parts by weight" and "% by weight", respectively.

Synthesis of polyfunctional phenol compound 1

A glass container equipped with a thermometer, stirrer, and condenser was charged with 564 g of phenol, 122 g of salicylaldehyde, and 0.3 g of concentrated hydrochloric acid. After reaction at 100 °C for 30 minutes, the glass container was further charged with 0.5 g of p-toluene-sulfonic acid. With the glass container equipped with a distillation unit, the reactants were heated to 180 °C and reaction was carried out at 180 °C for 2 hours, while distilling away excess phenol.

After the completion of reaction, the reaction product was dissolved in 500 g of methyl isobutyl ketone and the solution was washed with 1000 g of 3% aqueous solution of $NaHCO_3$ and then with 1000 g of distilled water to remove the catalyst. Solvent and unreacted phenol were removed by a rotary evaporator.

260 g of "polyfunctional phenol compound 1" was obtained, having a softening point of 115 °C and a hydroxyl equivalent of 98 g/eq.

Synthesis of polyfunctional phenol compound 2

The same glass container as above was charged with 168 g of 2,4-bis-hydroxymethyl-o-cresol and 324 g of o-cresol. After addition of 2 g of oxalic acid the reaction was carried out at 75 °C for 4 hours. The reaction product was dehydrated under reduced pressure and had unreacted o-cresol removed by steam distillation. 230 g of "polyfunctional phenol compound 2" was obtained having a softening point of 65 °C and a hydroxyl

equivalent of 118 g/eq.

Synthesis of polyfunctional phenol compound 3

The same glass container as above was charged with 228 g of bisphenol A, 24 g of 37% formalin, and 1 g of oxalic acid. The mixture was reacted at reflux temperature for 3 hours. The reaction product was dehydrated under reduced pressure. 230 g of "polyfunctional phenol compound 3" was obtained having a softening point of 68 °C and a hydroxyl equivalent of 118 g/eq.

Synthesis of phenol novolak compound 1

The same glass vessel as above was charged with 75 g of p-(t-butyl)phenol and 81 g of 37% formalin. 200 g of 10% NaOH aqueous solution was added dropwise to the vessel at 30 °C. Reaction was carried out at 30 °C for 1 hour followed by another 1 hour at 50 °C. After cooling to 30 °C, the reactants were neutralized with 123 g of an aqueous solution of 20% $H_2SO_4$. 110 g of oily resole was thus obtained. Next 162 g of o-cresol and 1 g of oxalic acid were added to this resole (110 g). This mixture was reacted at 75 °C for 4 hours, followed by dehydration under reduced pressure and steam distillation. 136 g of a "phenol novolak compound 1" was thus obtained comprising 33% by weight of trinuclear phenol novolak compound and 5% by weight of dinuclear phenol novolak compound.

Synthesis of phenol novolak compound 2

54 g of o-cresol and 81 g of 37% formalin were reacted according to the same procedure as above to prepare 84 g of oily resole. This resole (84 g) was reacted in the same manner as described above with 162 g of o-cresol to give 115 g of a "phenol novolak compound 2" comprising 48 wt% of trinuclear phenol novolak compound and 14% by weight of dinuclear phenol novolak compound.

Example 1

An epoxy resin (a) was produced from 8 parts of Phenol novolak compound 1, 59.7 parts of a bisphenol A type epoxy resin having an epoxy equivalent of 187 g/eq. (EPIKOTE 828) (EPIKOTE is a trade name) obtainable from Yuka Shell Epoxy Co., Ltd. and 32.3 parts of tetrabromobisphenol A, by reaction at 150 °C for 180 minutes in the presence of 0.03 part of 1,2-dimethylimidazole. An epoxy resin (a) according to the present invention was produced, hereafter referred to as "epoxy resin 1", having an epoxy equivalent weight of 707 g/eq.

An epoxy resin composition according to the present invention was prepared from one hundred parts of "Epoxy resin 1" 2 parts of dicyandiamide and 0.15 part of 2-ethyl-4-methylimidazole dissolved in a 1:1 (by weight) solvent blend of methyl ethyl ketone and ethylene glycol monomethyl ether to give varnish containing 55% by weight solids.

The varnish was impregnated into glass cloth, followed by drying at 130 °C for 7 minutes to give a prepreg containing 45% solids. Eight pieces of the prepregs were placed on top of the other between two sheets of 35-μm thick copper foil. They were heated at 170 °C under a pressure of 40 $kg/cm^2$ for 1 hour. In the end a 1.6-mm thick copper-clad glass epoxy laminate was obtained.

Example 2

An epoxy resin (a) was produced in the same manner as in Example 1 from 7 parts of Phenol novolak compound 2, 60.7 parts of EPIKOTE 828 and 32.3 parts of tetrabromobisphenol A.

A product hereafter referred to as "Epoxy resin 2" having an epoxy equivalent weight of 690 g/eq was prepared.

A varnish was prepared from Epoxy resin 2 and a copper-clad glass epoxy laminate was prepared from the varnish, both in the same manner as described in Example 1.

Example 3

An epoxy resin (a) was produced in the same manner as in Example 1 from 64.5 parts of EPIKOTE 828, 5 parts of polyfunctional phenol compound 1 and 30.5 parts of tetrabromobisphenol A.

A product, hereafter referred to as "Epoxy resin 3" having an epoxy equivalent weight of 551 g/eq was thus

prepared.

A varnish was prepared from Epoxy resin 3 and a copper-clad epoxy resin laminate was prepared from the varnish both essentially in the same manner as described in Example 1, except for the use of 2.5 parts of dicyandiamide and 0.15 parts of 2-ethyl-4-methyl- imidazole.

Example 4

An epoxy resin (a) was produced in the same manner as in Example 1 from 62.5 parts of EPIKOTE 828, 7 parts of Polyfunctional phenol compound 2, and 30.5 parts of tetrabromobisphenol A.

A product hereafter referred to as "Epoxy resin 4" was obtained having an epoxy equivalent weight of 615 g/eq.

A varnish was prepared from "Epoxy resin 4" and a copper-clad glass epoxy resin laminate was prepared from the varnish both in the same manner as in Example 3.

Example 5

An epoxy resin (a) was produced in the same manner as in Example 1 from 61.5 parts of EPIKOTE 828, 8 parts of Polyfunctional phenol compound 3, and 30.5 parts of tetrabromobisphenol A.

A product hereafter referred to as "Epoxy resin 5" was obtained having an epoxy equivalent weight of 673 g/eq.

A varnish was prepared from "Epoxy resin 5" and a copper-clad glass epoxy resin laminate was prepared from the varnish both in the same manner as in Example 3.

Comparative Example 1

A mixed epoxy resin was prepared from 92 parts of brominated bisphenol type epoxy resin having an epoxy equivalent of 748 g/eq. and containing 28% bromine (EPIKOTE 5049 from Yuka Shell Epoxy Co., Ltd.) and 8 parts of o-cresol novolak type epoxy resin having an epoxy equivalent of 208 g/eq. (EPIKOTE 180S70 from Yuka Shell Epoxy Co., Ltd.)

The resin obtained is hereafter referred to as "comparative resin 1".

Comparative Example 2

An epoxy resin was produced in the same manner as in Example 1 from 8 parts of o-cresol novolak (having a softening point of 100 °C), 59.7 parts of EPIKOTE 828 and 32.3 parts of tetrabromobisphenol A.

A product hereafter referred to as "comparative resin 2" was obtained having an epoxy equivalent weight of 713 g/eq.

Comparative Example 3

An epoxy resin was produced in the same manner as in Example 1 from 10 parts of EPIKOTE 180S70, 57.7 parts of EPIKOTE 828 and 32.3 parts of tetrabromobisphenol A.

A product hereafter referred to as "comparative resin 3" was obtained having an epoxy equivalent weight of 423 eq/g.

Comparative Example 4

A mixed epoxy resin was prepared from 90 parts of EPIKOTE 5049 and 10 parts of EPIKOTE 180S70.

The resin obtained is hereafter referred to as "comparative resin 4".

Comparative Example 5

An epoxy resin was produced in the same manner as in Example 1 from 61.5 parts of EPIKOTE 828, 8 parts of o-cresol novolak (having a softening point of 100 °C and a hydroxyl equivalent weight of 118 g/eq), and 30.5 parts of tetrabromobisphenol A.

A product hereafter referred to as "comparative resin 5" was obtained having an epoxy equivalent weight of 680 g/eq.

Comparative Example 6

An epoxy resin was produced in the same manner as in Example 1 from 54.5 parts of EPIKOTE 828, 15 parts of EPIKOTE 157S70 and 30.5 parts of tetrabromobisphenol A.

A product hereafter referred to as "comparative resin 6" was obtained having an epoxy equivalent weight of 400 g/eq.

Varnishes from comparative resins 1 to 3 and copper-clad epoxy resin laminates prepared from these varnishes were prepared in the same manner as in Example 1.

Varnishes from comparative resins 4 to 6 and copper-clad epoxy resin laminates prepared from these varnishes were prepared in the same manner as in Example 3.

Tables 1 and 2 show the physical properties of the uncured resin and the cured laminates prepared therewith according to all Examples and Comparative Examples.

From the data presented in said tables it follows that the epoxy resin compositions according to the Examples are superior to those according to the Comparative Examples with respect to impregnation into glass cloth and the ability to yield laminates having well-balanced physical properties.

Table 1

| Physical properties of the resin/laminate | Example No. 1 | Example No. 2 | Comparative Example No. 1 | Comparative Example No. 2 | Comparative Example No. 3 |
|---|---|---|---|---|---|
| Glass transition point (°C) *1 | 134 | 136 | 123 | 130 | 128 |
| Peel strength of copper foil (kgf/cm) | 2.3 | 2.4 | 2.4 | 2.3 | 2.3 |
| Solder resistance after treatment by pressure cooker (measling resistance) *2 | good | good | fair | poor | poor |
| Moisture absorption (% by weight) *3 | 0.80 | 0.85 | 1.15 | 1.21 | 1.11 |
| Drillability *4 | good | good | good | poor | fair |
| Impregnation into glass cloth *5 | good | good | good | poor | fair |

*1 Measured by the dynamic viscoelastic method.

*2 The sample was heated in a pressure cooker at 120 °C and 2 atm. for 4 hours and then dipped in the soldering bath at 260 °C for 30 seconds. The sample was examined for blistering and peeling.

good: no blistering and peeling at all

fair: slight blistering and peeling

poor: blistering and peeling

*3 Measured after conditioning at 40 °C and 90% RH for 100 hours.

*4 By visual inspection of resin smear.

drill: 0.4 mm in dia., 60,000 rpm, 1.0 m/min feed

*5 Rated by visual inspection at the time of impregnation and application to glass cloth.

Table 2

| Physical properties of the resin/laminate | Example No. 3 | Example No. 4 | Example No. 5 | Comparative Example No. 4 | Comparative Example No. 5 | Comparative Example No. 6 |
|---|---|---|---|---|---|---|
| Polydispersity index | 2.5 | 2.3 | 2.7 | 1.7 | 3.4 | 3.2 |
| Initial gel time (s) *1 | 110 | 120 | 115 | 140 | 135 | 120 |
| Gel time after 14 days | 99 | 110 | 101 | 126 | 54 | 66 |
| Retention (%) of initial gel time | 90 | 92 | 88 | 90 | 40 | 50 |
| Impregnation into glass cloth *2 | good | good | good | good | poor | poor |
| Glass transition Temperature (°C) *3 | 141 | 134 | 136 | 125 | 136 | 138 |
| Copper foil peel strength (kgf/cm) | 2.3 | 2.4 | 2.4 | 2.4 | 2.3 | 2.3 |
| Measling resistance *4 | good | good | good | fair | poor | poor |
| Drillability *5 | good | good | good | good | poor | fair |

Remarks:

*1 Gel time measured at 160 °C.

*2 Judged by visual inspection.

*3 Measured by the dynamic viscoelastic method.

*4 The sample was heated in a pressure cooker at 120 °C and 2 atm. for 4 hours and then dipped in the soldering bath at 260 °C for 30 seconds. The sample was examined for blistering and peeling.

good: no blistering and peeling at all

fair: slight blistering and peeling

poor: blistering and peeling

*5 By visual inspection of resin smear.

drill: 0.4 mm in dia., 60,000 rpm, 1.0 m/min feed.

The polydispersity index is expressed in terms of the ratio of Mw/Mn, where Mn is the number-average molecular weight and Mw is the weight-average molecular weight, both measured by gel permeation chromatography (GPC) using four columns in series and tetrahydrofuran (THF) as a solvent (the first column containing TSK gel G4000 Hx1, the second and third columns containing TSK gel G3000 Hx1, and the fourth column

containing TSK gel G2000 Hx1, all gels made by Tosoh Corporation).

## Claims

1. An epoxy resin (a), having a polydispersity index of molecular weight distribution (ratio of Mw/Mn) lower than 3.0, obtainable by reacting:
   A) a difunctional epoxy resin having the skeleton of at least one bisphenol compound selected from bisphenol A, bisphenol F and tetrabromobisphenol A,
   B) from 1 to 20% by weight based on the total weight of the components A, B and C, of a polyfunctional phenol compound, and
   C) at least one bisphenol compound selected from bisphenol A, bisphenol F, and tetrabromobisphenol A.

2. An epoxy resin as claimed in claim 1 wherein the polyfunctional phenol compound used in component (B) is selected from (1) a polyfunctional phenol compound obtained by reacting an aldehyde or ketone compound having a hydroxyl group-substituted phenyl group with a phenol compound in the presence of an acid catalyst, (2) a polyfunctional phenol compound obtained by reacting a phenol-based dimethylol compound or phenol-based novolak dimethylol compound with a phenol compound in the presence of an acid catalyst, (3) a polyfunctional phenol compound obtained by reacting a phenol compound with formaldehyde in the presence of an acid catalyst and (4) a phenol novolak compound containing:
   i) more than 20% by weight based on the total weight of phenol novolak compound (4) of trinuclear phenol novolak compound represented by formula I

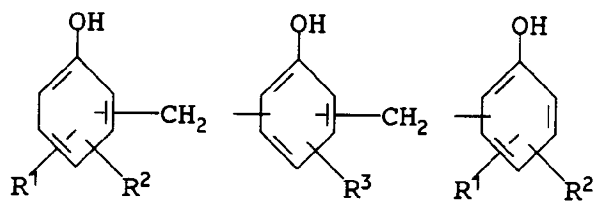

(I)

   wherein $R^1$, $R^2$ and $R^3$ each independently is a hydrogen atom or an alkyl group having from 1 to 3 carbon atoms, and
   ii) less than 20% by weight based on the total weight of phenol novolak compound (4) of a dinuclear phenol novolak compound, represented by the formula II

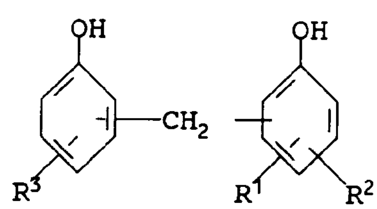

(II)

   wherein $R^1$, $R^2$ and $R^3$ are as defined above.

3. Process for the preparation of an epoxy resin as claimed in claim 1 or 2 wherein the three components (A) (B) and (C) are reacted at a temperature of from 100-200 °C for a period of from 60-200 minutes optionally in the presence of a catalyst.

4. An epoxy resin composition comprising:
   i) an epoxy resin (a) as claimed in claim 1 or 2,
   ii) a curing compound,and
   iii) a curing accelerator.

5. An epoxy resin composition as claimed in claim 4 comprising in addition to epoxy resin (a) an epoxy resin differing from epoxy resin (a) having two or more epoxy groups per molecule in an amount of less than

50% by weight based on the total weight of epoxy resin (a) and said epoxy resin differing from epoxy resin (a).

**6.** A copper clad epoxy resin laminate comprising an epoxy resin composition as claimed in claim 4 or 5 in the cured state.

**7.** A printed circuit board prepared from a laminate as claimed in claim 6.

European Patent Office

# EUROPEAN SEARCH REPORT

Application Number
EP 94 20 0037

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | EP-A-0 316 509 (THE DOW CHEMICAL COMPANY) * page 7, line 10 - line 46; claims; examples * * page 8, line 1 - line 12 * | 1-7 | C08G59/06 H05K1/03 |
| X | GB-A-1 115 611 (UNION CARBIDE CORPORATION) * claims; examples * | 1-7 | |
| X | US-A-4 608 406 (P.R. WILLIAMS E. A.) * column 2, line 3 - column 3, line 3; claims; examples 1-3 * | 1-7 | |
| P,X | EP-A-0 556 421 (THE DOW CHEMICAL COMPANY) * claims * | 1-7 | |
| X | DE-A-25 05 345 (HOECHST AG) * page 6, paragraph 2; claims * | 1-7 | |

TECHNICAL FIELDS SEARCHED (Int.Cl.5)
C08G

The present search report has been drawn up for all claims

| Place of search | Date of completion of the search | Examiner |
|---|---|---|
| THE HAGUE | 3 May 1994 | Deraedt, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)